Europäisches Patentamt

European Patent Office

Office européen des brevets

(11) Veröffentlichungsnummer: **0 357 815**

**A1**

(12) **EUROPÄISCHE PATENTANMELDUNG**

(21) Anmeldenummer: 88114531.2

(22) Anmeldetag: 06.09.88

(51) Int. Cl.5 **G05F 1/46 , H03K 19/091**

(43) Veröffentlichungstag der Anmeldung:
**14.03.90 Patentblatt 90/11**

(84) Benannte Vertragsstaaten:
**AT BE CH DE ES FR GB GR IT LI LU NL SE**

(71) Anmelder: **Siemens Aktiengesellschaft
Wittelsbacherplatz 2
D-8000 München 2(DE)**

(72) Erfinder: **Wondra, Jürgen, Dipl.-Ing-
G.-Mahler-W. 11
D-8011 Baldham(DE)**

(54) **Schaltbare Konstantstromquelle mit I2L-Gattern.**

(57) Um eine schaltbare Konstantstrom mit $I^2L$-Gattern zu realisieren, deren Ausgangsstrom in festem Zusammenhang zu einer Referenzgröße steht, werden mindestens zwei $I^2L$-Gatter eingesetzt, wobei eines als Referenzgatter vorgesehen ist, dessen Ausgangsstrom über eine Regelschaltung in Abhängigkeit von einer Führungsgröße durch Verändern des Injektorstromes ausgeregelt wird. Die Injektoranschlüsse aller verwendeten $I^2L$-Gatter werden gemeinsam von einem in dieser Regelstrecke enthaltenen Regelverstärker mit Strom versorgt und die Stromausgänge der nicht als Referenzgatter vorgesehenen $I^2L$-Gatter stellen einen quasi-geregelten Konstantstrom bereit, der über ihre jeweiligen Steuereingänge schaltbar ist.

FIG 5

## Schaltbare Konstantstromquelle mit I²L-Gattern

Die vorliegende Erfindung betrifft schaltbare Konstantstromquellen in Form monolithisch integrierter Schaltungen nach dem Oberbegriff des Patentanspruches 1.

In monolithisch integrierten bipolaren Schaltungen hat sich die I²L-Technologie (Integrated Injektion Logic) für die Realisierung einzelner Logik-Schaltungsteile, wie Invertiererschaltungen, Flip-Flops, Zähler etc. mit sehr geringem Chipflächenbedarf bewährt. Ein I²L-Gatter benötigt üblicherweise nur eine Isolatorwanne auf dem Halbleiterchip und außerdem können beim Aufbau mehrerer gleichartiger I²L-Gatter die Injektoreingänge aller I²L-Gatter durch einfaches Parallelschalten über eine eizige Stromeinprägung versorgt werden.

I²L-Gatter sind unter anderem aus der Zeitschrift IEEE Journal Of Solid-State Circuits, Vol. SC-12, No. 5, October 1977 aus dem Artikel "Electrical Parameters, Static and Dynamic Response of I²L" von Teunis Poorter, Seiten 440 bis 449 und dem Artikel "Theshold I²L and Its Applications to Binary Symmetric Functions and Multivalued Logic" von T. Tich Dao, Seiten 463 bis 472 sowie aus der Zeitschrift IEEE Journal Of Solid-State Circuits, Vol. SC-14, No. 1, February 1979 aus dem Artikel "A Single-Chip I²L PCM Codec" von R.A. Blauschild et al, Seiten 59 bis 64 bekannt.

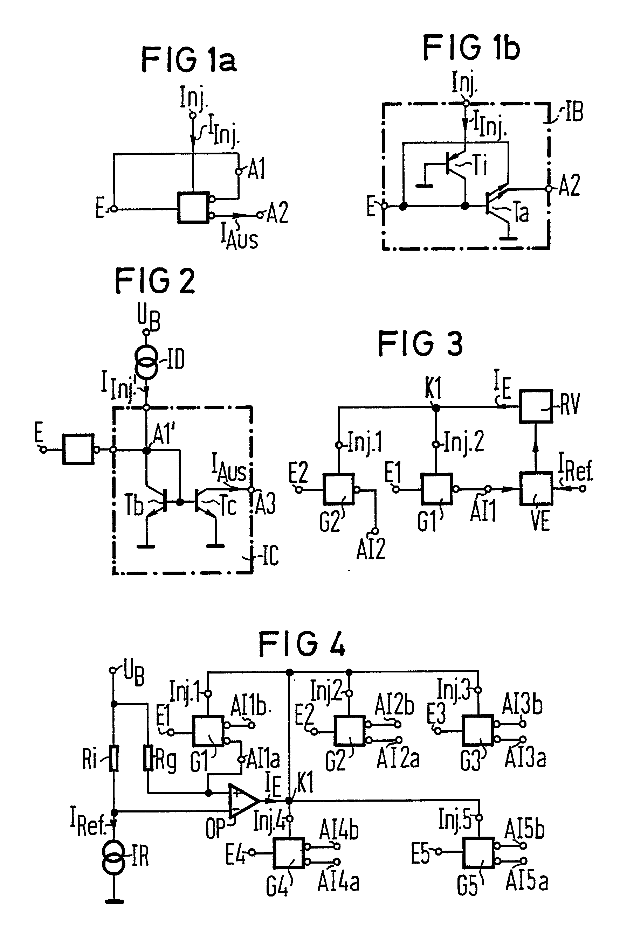

Der bekannte Stand der Technik wird nachstehend anhand der Figuren 1A, 1B und 2 beschrieben. Es zeigt

FIG 1A das übliche Schaltzeichen eines I²L-Gatters mit zwei Stromausgängen A1 und A2, einem Injektoreingang Inj und einem Steuereingang E, wobei dieses I²L-Gatter durch Verbinden eines Stromausganges A1 mit dem Steuereingang E als schaltbare Stromquelle wirkt;

FIG 1B das gleiche I²L-Gatter wie FIG 1A, jedoch mit Darstellung der das Gatter realisierenden Transistorschaltung;

FIG 2 eine in ihrer Wirkung mit der in FIG 1 gezeigten Schaltung vergleichbare, durch Einzeltransistoren realisierte schaltbare Stromquelle nach dem Stande der Technik.

Ein typisches I²L-Gatter ist in FIG 1B gezeigt. Solche I²L-Gatter sind in integrierter Technik sehr platzsparend in nur einer Isolationswanne realisierbar. Das in FIG 1B gezeigte I²L-Gatter besitzt einen Steuereingang E, der mit einem Steuersignal beaufschlagbar ist, einen Injektoreingang Inj, der mit dem Stromeingang eines ersten Transistors Ti vom einen Typ, hier mit dem Emitter eines pnp-Transistors verbunden ist und der mit einem eingeprägten Strom $I_{Inj}$ beaufschlagt ist und mehrere Ausgänge, hier zwei Ausgänge A1, A2, die jeweils mit einer eigenen, als Kollektor wirkenden Anschlußelektrode eines Ausgangstransistors Ta vom zum Transistor Ti inversen Typ, hier also eines npn-Transistors, verbunden sind. Weil der Ausgangstransistor Ta mehrere Kollektoren als Ausgänge benötigt, wird er durch einen revers betriebenen Multiemittertransistor realisiert. Der Basisanschluß des ersten Transistors Ti sowie der als Emitter wirkende Kollektoranschluß des Ausgangstransistors Ta sind beide gegen ein festes Potential, vorzugsweise das Bezugspotential, geschaltet. Der Stromausgang des ersten Transistors Ti, hier der Kollektoranschluß, bildet gemeinsam mit dem Basisanschluß des Ausgangstransistors Ta den Steuereingang E des I²L-Gatters. Ist, wie in FIG 1A und 1B gezeigt, ein Stromausgang, hier der Stromausgang A1, mit dem Steuereingang E zusammengeschaltet, so erhält man eine Stromspiegelschaltung IB mit dem resultierenden Schaltungsaufbau, wie er in FIG 2 als diskret aufgebaute Stromspiegelschaltung IC dargestellt ist. Solche Stromspiegelschaltungen sind bekannt und unter anderem in dem Buch "Halbleiter-Schaltungstechnik" von Tietze, Schenk, 7. Auflage, 1985 auf den Seiten 61 bis 64 beschrieben. Speziell auf Seite 63 dieses Buches ist der Zusammenhang zwischen dem Eingangsstrom, hier dem am Injektoreingang eingespeisten Injektorstrom $I_{Inj}$ bzw. $I_{Inj}'$, und dem Ausgangsstrom $I_{Aus}$ beschrieben:

$$I_{Aus} = \frac{B}{B + 2} I_{Inj}$$

wobei B der Stromverstärkungsfaktor des Ausgangstransistors Ta ist. Für große Stromverstärkungsfaktoren B wäre der Ausgangsstrom nahezu gleich dem Eingangsstrom.

Bei I²L-Gattern wird jedoch ein invers betriebener Multiemittertransistor als Ausgangstransistor Ta eingesetzt. Übliche Transistoren zeichen sich durch eine sehr kleine Stromverstärkung $B_{inv}$ im Rückwärtsbetrieb aus. Durch eine modifizierte Basisschicht ist bei I²L-Gatter-Transistoren ein entsprechender Stromverstärkungsfaktor $B_{inv}$ von ca. 2 bis 5 erreichbar. Wenn mehrere I²L-Gatter im gleichen Arbeitsgang auf einem Chip hergestellt werden, sind die Stromverstärkungsfaktoren $B_{inv}$ der einzelnen Gatter-Transistoren in hohem Maße gleich groß. Bei im Rahmen einer industriellen Großfertigung hergestellten Chips unterliegen die Stromverstärkungsfaktoren $B_{inv}$ von auf unterschiedlichen Chips befindlichen I²L-Transistoren einer sehr großen Streubreite, die Werte liegen zwischen $B_{inv} = 2$ und $B_{inv} = 5$. Aufgrund dieser großen Schwankungsbreite der einzelnen Stromverstärkungsfaktoren von auf verschiedenen Chips realisierten I²L-Gatter-Transistoren sind Stromspiegelschaltungen, wie sie in FIG 1A und 1B gezeigt sind, als Konstantstromquelle kaum einsetzbar, denn der Wert des Ausgangsstromes $I_{Aus}$ kann zwischen dem 0,5-fachen und dem 0,27-fachen Wert des Injektorstromes $I_{Inj}$ liegen.

Vorteile solcher durch $I^2L$-Gatter realisierter Stromquellen liegen darin, daß sie sehr klein sind, daß mehrere solcher auf einem Chip realisierte Stromquellen nur eine gemeinsame Stromeinprägung als Referenzstromquelle benötigen und daß sie durch Variation des am Signaleingang E anliegenden Potential einfach ein- oder ausschaltbar sind.

Um eine schaltbare Konstantstromquelle mit Hilfe einer Stromspiegelschaltung zu realisieren, deren Ausgangsstrom genauer reproduzierbar ist, benötigt man, wie aus der oben genannten Formel ersichtlich ist, einen möglichst hohen Stromverstärkungsfaktor, wie er mit $I^2L$-Zellentransistoren nicht erreichbar ist. Wird eine in FIG 2 gezeigte Stromspiegelschaltung, die prinzipiell unter anderem aus dem oben genannten Buch "Halbleiter-Schaltungstechnik" bekannt ist, durch zwei einzeln realisierte Transistoren Tb und Tc in Verbindung mit einer einen Referenzstrom $I_{Inj}'$ bereitstellenden Stromeinprägung ID realisiert und wird zum entsprechend einfachen, entkoppelten Ein-bzw. Ausschalten ein einen Steuereingang E aufweisendes Gatter GE mit seinem Ausgang an den Verbindungsknoten A' zwischen der Stromeinprägung ID, dem Kollektor und der Basis des Transistors Tb und der Basis des Transistors Tc geschaltet, so stellt der Stromausgang A3 dieser Schaltung einen konstanten Strom $I_{Aus}$ bereit, der weitgehend gleich groß ist wie der Referenzstrom $I_{Inj}'$ und der über ein Potential am Steuereingang E ein- oder ausschaltbar ist. Um eine solche Schaltung zu realisieren, sind jedoch mindestens vier Isolationswannen und somit eine erheblich größere Chipfläche erforderlich, als zur Realisierung einer vorgehend beschriebenen $I^2L$-Gatter-Stromquelle, die mit einer, etwas größeren Isolationswanne auskommt. Wenn mehrere solcher Stromquellenschaltungen, wie in FIG 2 eine einzelne gezeigt ist, auf einem Chip integriert werden, so benötigt jede einzelne dieser Stromquellenschaltungen eine eigene, den Referenzstrom $I_{Inj}'$ bereitstellende Stromeinprägung ID.

Der in FIG 2 mit A1' bezeichnete Schaltungsknoten entspricht in seiner Wirkung em in FIG 1A und 1B durch den Steuereingang E und den Stromausgang A1 gebildeten Schaltungsknoten.

Aufgabe der Erfindung ist das Bereitstellen einer schaltbaren Konstantstromquelle in Form einer monolithisch integrierbaren elektronischen Schaltung mit möglichst geringem Chipflächenbedarf, bei der auch bei großer Serienfertigung über einen längeren Zeitraum ein fester Zusammenhang zwischen einer vorgebbaren elektrischen Größe und dem Stromquellenausgangsstrom besteht.

Diese Aufgabe wird durch eine schaltbare Konstantstromquelle mit den Merkmalen des Patentanspruches 1 gelöst. Günstige Ausgestaltungsformen sind Gegenstand von Unteransprüchen.

Die Erfindung basiert auf der Tatsache, daß mehrere $I^2L$-Gatter, die im gleichen Arbeitsgang auf einem Chip hergestellt werden, nahezu identische technische Daten, wie Stromverstärkungsfaktor oder Eingangsimpedanzen besitzen. Werden beispielsweise mehrere $I^2L$-Gatter zu einem Schaltungsknoten zusammengeschaltet und wird dieser Schaltungsknoten mit einem Injektorgesamtstrom beaufschlagt, so verteilt sich dieser Injektorgesamtstrom auf alle an diesem Knoten angeschlossene Injektoreingänge zu gleichen Teilen. Werden erfindungsgemäß mehrere $I^2L$-Gatter mit ihren Injektoreingängen zu einem Schaltungsknoten zusammengeschaltet und der diesem Schaltungsknoten eingeprägte Injektorgesamtstrom als Stellgröße einer Regelschleife derart geregelt, daß eines dieser $I^2L$-Gatter, das als Referenzgatter vorgesehen ist, als Regelstrecke eingesetzt ist, wobei an seinem Injektoreingang der entsprechende Teil der besagten Stellgröße eingespeist wird und wobei sein Ausgangsstrom mit einer Führungsgröße verglichen wird und die sich daraus ergebende Regeldifferenz einen Regelverstärker steuert, so sind die Ausgangsströme der übrigen $I^2L$-Gatter quasi-geregelt konstant.

Nachstehend wird die Erfindung anhand der Figuren 3, 4 und 5 näher erläutert. Schaltungsteile, die eine ähnliche oder die gleiche Funktion erfüllen sind hierbei mit ähnlichen oder gleichen Bezugszeichen versehen.

Es zeigt

FIG 3 ein Prinzipschaltbild einer erfindungsgemäßen Konstantstromquelle;

FIG 4 eine Ausführungsform, bei der die in FIG 3 gezeigte Vergleichereinrichtung VE und der Regelverstärker RV durch einen Operationsverstärker OP realisiert sind;

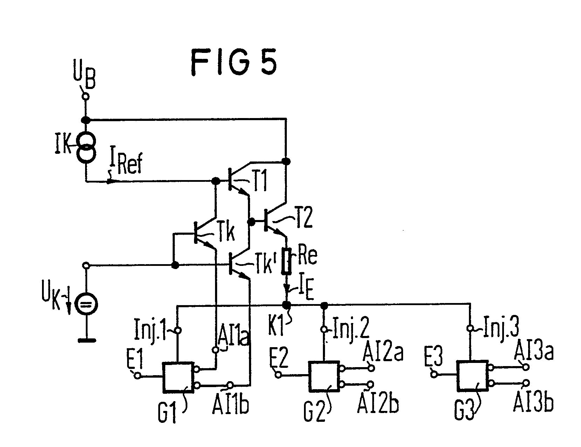

FIG 5 eine besonders günstige Ausgestaltungsform, die sehr wenig Chipfläche bedarf und deren Funktionssicherheit durch verschiedene Stabilisierungsmaßnahmen verbessert ist.

FIG 3 zeigt als Prinzipschaltbild eine erfindungsgemäßen schaltbare Konstantstromquelle mit zwei identisch aufgebauten $I^2L$-Gattern G1 und G2, deren Injektoreingänge INJ1 und INJ2 gemeinsam einen ersten Schaltungsknoten K1 bilden. Eine erfindungsgemäße schaltbare Konstantstromquelle benötigt mindestens zwei $I^2L$-Gatter, es können aber auch nahezu beliebig viele $I^2L$-Gatter vorgesehen sein, die jeweils mit ihren Injektoreingängen zusammengeschaltet sind. Ein Stromausgang A11 des ersten $I^2L$-Gatters G1 ist mit einem Eingang einer Vergleichereinrichtung VE zusammengeschaltet, die den Ausgangsstrom $I_{G1}$ dieses ersten $I^2L$-Gatters mit einer Führungsgröße, insbesondere einem Referenzstrom $I_{Ref}$, vergleicht und deren Ausgangsgröße einen Regelverstärker RV steuert, wobei die Ausgangsgröße dieses Regelverstärkers als Stellgröße dem Injektorgesamtstrom $I_E$ entspricht und dem ersten Schaltungsknoten K1 eingeprägt wird.

Bei identisch aufgebauten $I^2$L-Gattern wird dieser Injektorgesamtstrom $I_E$ zu gleichen Teilen auf alle an diesem ersten Schaltungsknoten K1 angeschlossenen Injektoreingänge verteilt. Beispielsweise wird bei zwei $I^2$L-Gattern G1 und G2 jedem Injektoreingang ein Injektorstrom eingeprägt, der halb so groß ist wie der Injektorgesamtstrom $I_E$. Der Ausgangsstrom der nicht als Referenzgatter geschalteten $I^2$L-Gatter, in FIG 2 also des $I^2$L-Gatters G2, ist als Ausgangsstrom der schaltbaren Konstantstromquelle vorgesehen und ist in Abhängigkeit von der Ansteuerung des Steuereingangs E2 dieses $I^2$L-Gatters G2 schaltbar.

FIG 4 zeigt als Ausführungsbeispiel einer erfindungsgemäßen schaltbaren Konstantstromquelle eine Schaltung, gebildet aus fünf identisch aufgebauten $I^2$L-Gattern G1, G2, G3, G4, G5, deren Injektoreingänge Inj1, Inj2, ... gemeinsam an einen ersten Schaltungsknoten K1 geschaltet sind. Im Ausführungsbeispiel der FIG 4 sind $I^2$L-Gatter mit zwei Stromausgängen AI1a, AI1b, AI2a, AI2b, AI3a, ... vorgesehen, so daß insgesamt acht Stromausgänge AI2a, AI2b, ..., AI5b der schaltbaren Konstantstromquelle zur Verfügung stehen, die in Abhängigkeit vom an den Steuereingängen E2, E3, E4 und E5 anliegenden Potential paarweise schaltbar sind. Ein Stromausgang AI1a des ersten $I^2$L-Gatters G1 ist an den invertierenden Eingang eines Operationsverstärkers OP mit Differenzverstärkereingang und gleichzeitig über einen Widerstand Rg an das Versorgungspotential $U_B$ geschaltet. Der nichtinvertierende Eingang dieses Operationsverstärkers OP ist mit einer Stromeinprägung IR verbunden und über einen Widerstand Ri an das Versorgungspotential $U_B$ geschaltet. Der Operationsverstärker OP stellt an seinem Ausgang, der mit dem ersten Schaltungsknoten K1 verbunden ist, den Injektorgesamtstrom $I_E$ bereit.

Wenn in einem Ausführungsbeispiel die Widerstände Ri und Rg gleich groß sind, wird der Strom des an den Operationsverstärkereingang rückgekoppelten Stromausganges AI1a des ersten $I^2$L-Gatters G1 derart geregelt, daß er gleich groß ist, wie der von der Stromeinprägung IR bereitgestellte Referenzstrom $I_{Ref}$. Aufgrund des übereinstimmenden Verhaltens aller in dieser Konstantstromquelle enthaltenen $I^2$L-Gatter G1, G2, ... G5 sind die Ausgangsströme an den übrigen Stromausgängen AI1b, AI2a, AI2b, ... der $I^2$L-Gatter G1, G2, ... ebenfalls so groß wie der Referenzstrom $I_{Ref}$.

FIG 5 zeigt eine besonders vorteilhafte Ausführungsform einer erfindungsgemäßen schaltbaren Konstantstromquelle mit drei identisch aufgebauten $I^2$L-Gattern G1, G2 und G3. Die Anzahl dieser $I^2$L-Gatter ist aber weitgehend beliebig und hängt nur von den an die schaltbare Konstantstromquelle gestellten Anforderungen ab. Die in FIG 5 dargestellten $I^2$L-Gatter G1, G2 und G3 weisen jeweils einen Steuereingang E1, E2 und E3, einen Injektoreingang Inj 1, Inj 2 und Inj 3 sowie zwei schaltbare Stromausgänge AI1a, AI1b, AI2a, AI2b, AI3a und AI3b auf. Auch die Anzahl der Stromausgänge jedes $I^2$L-Gatters ist beliebig und hängt nur von den Anforderungen an die schaltbare Konstantstromquelle ab. Die Stromausgänge AI2a, AI2b, AI3a und AI3b der $I^2$L-Gatter G2 und G3 sind als Stromausgänge der schaltbaren Konstantstromquelle vorgesehen und können über ein entsprechendes, an die Steuereingänge E2 und E3 dieser $I^2$L-Gatter angelegtes Potential geschaltet werden. Der erste Stromausgang AI1a des als Referenzgatter vorgesehenen ersten $I^2$L-Gatters G1 ist mit dem Emitteranschluß eines Transistors Tk verbunden, der zweite Stromausgang AI1b dieses ersten $I^2$L-Gatters G1 ist in gleicher Weise mit dem Emitter eines weiteren Transistors Tk′ verbunden. Der Kollektoranschluß des Transistors Tk bildet mit dem Basisanschluß eines Transistor T1 und dem Stromausgang einer Referenzstromquelle IK einen zweiten Schaltungsknoten K2. Der Emitteranschluß des Transistors T1 ist mit dem Basisanschluß eines Transistors T2 und mit dem Kollektoranschluß des Transistors Tk′ zusammengeschaltet. Die Kollektoranschlüsse der als Darlingtonstufe geschalteten Transistoren T1 und T2 sind gemeinsam an das Versorgungspotential $U_B$ angeschlossen. Der Emitteranschluß des Transistors T2 ist über einen Widerstand Re an einen ersten Schaltungsknoten K1 geschaltet. Die Injektoreingänge Inj1, Inj2 und Inj3 aller $I^2$L-Gatter G1, G2 und G3 sind ebenfalls an diesen ersten Schaltungsknoten K1 angeschlossen. Die Basisanschlüsse der Transistoren Tk und Tk′ sind an ein konstantes Potential $U_K$ geschaltet.

Im Prinzip ist die in FIG 5 eingesetzte Regelschaltung sehr einfach. Der Ausgangsstrom des als Referenzgatter vorgesehen ersten $I^2$L-Gatters G1 wird in einem zweiten Schaltungsknoten K2 mit dem von einer Konstantstromquelle IK bereitgestellten Referenzstrom $I_{Ref}$ verglichen. An diesen zweiten Schaltungsknoten K2 ist außerdem der Basisanschluß des als Regelverstärker dienenden Transistors T1 angeschlossen, dessen Emitterstrom prinzipiell unmittelbar als Injektorgesamtstrom dem ersten Schaltungsknoten K1 eingeprägt werden könnte. Da jedoch der Basisstrom des Transistors T1 in der Kirchhoff'schen Knotengleichung des zweiten Schaltungsknotens K2 als Fehlerstrom enthalten ist, sollte der Regelverstärker-Transistor T1 einen möglichst großen Stromverstärkungsfaktor aufweisen, um diesen Fehlerstrom möglichst klein zu halten. Deshalb wird er durch einen weiteren Transistor T2 zu einem Darlington-Transistor mit hohem Stromverstärkungsfaktor ergänzt.

Ein Widerstand Re zwischen dem Ausgang des Regelverstärkers, hier dem Emitter des Transistors T2, und dem ersten Schaltungsknoten K1 verhindert Regelschwingungen. Ein solcher Widerstand ist auch bei anderen Ausführungsformen erfindungsgemäßer schaltbarer Konstantstromquellen empfehlenswert.

Um die Darlington-Stufe T1, T2 zu stabilisieren, wird der Emitter des Eingangstransistors T1 der Darlington-Stufe nicht nur an die Basis des Ausgangstransistors T2 der Darlington-Stufe geschaltet, sondern auch über eine Konstantstromquelle an das Bezugspotential. Da die in der in FIG 5 gezeigten Konstantstromquelle eingesetzten I²L-Gatter G1, G2, ... je zwei Stromausgänge AI1a, AI1b, AI2a, ... aufweisen, von dem als Referenzgatter vorgesehenen ersten I²L-Gatter jedoch nur der Strom eines Ausganges AI1a als Istwert für die Regelung benötigt wird, erweist es sich als günstig, den anderen Stromausgang AI1b dieses I²L-Gatters G1 zur Stabilisierung der Darlington-Schaltung an den Emitter des Transistors T1 zu schalten.

Bei erfindungsgemäßen schaltbaren Konstantstromquellen erweist es sich als besonders günstig, den Steuereingang E1 des als Referenzgatter vorgesehenen I²L-Gatters G1 unbeschaltet zu lassen. Die speziellen Transistoren in I²L-Gattern weisen üblicherweise bei unbeschaltetem Steuereingang eine sehr geringe Kollektor-Emitter-Durchbruch-Spannung $U_{CE}$ auf. Deshalb muß ein Durchbruch des Ausgangstransistors dieses I²L-Gatters G1 verhindert werden. Außerdem besteht die Gefahr, daß das erste I²L-Gatter G1 in die Sättigung geht, so daß auch dann kein Zusammenhang mehr zwischen dem geregelten Strom des ersten I²L-Gatters G1 und den Ausgangsströmen der übrigen I²L-Gatter G2, G3, G4,... besteht. Um die Betriebssicherheit erfindungsgemäßer Schaltungen zu gewährleisten, ist es deshalb empfehlenswert, alle beschalteten Stromausgänge AI1, AI1a, AI1b des als Referenzgatter vorgesehenen ersten I²L-Gatters jeweils mit dem Emitteranschluß eines als Kaskodeschaltung geschalteten Transistors Tk, Tk' zu verbinden und jeweils den Kollektoranschluß dieses Transistors Tk, Tk' als mittelbaren Stromausgang dieses ersten I²L-Gatters G1 zu beschalten. Das Potential $U_K$ am Basisanschluß dieses als Kaskodeschaltung geschalteten Transistors Tk, Tk' muß so gewählt werden, daß das I²L-Gatter nicht in die Sättigung gehen kann. Ein günstiger Wert für dieses Basispotential ist die doppelte PN-Übergangsspannung, bei Silizium-Schaltungen also ca. 1,4 V. Dadurch wird der Ausgang des I²L-Gatters G1 auf ca. 0,7 V festgelegt.

## Ansprüche

1. Monolithisch integrierte schaltbare Konstantstromquelle mit I²L-Gattern, **dadurch gekennzeichnet,** daß ein fester Zusammenhang zwischen einer vorgebbaren elektrischen Größe ($I_{Ref}$, $U_{Ref}$) und dem schaltbaren konstanten Ausgangsstrom ($I_{G2}$, $I_{G3}$ ...) der Konstantstromquelle besteht, daß mindestens zwei identisch aufgebaute I²L-Gatter (G1, G2, ...) mit je einem Injektoreingang (Inj1, Inj2, Inj3, ...), mit je einem Steuereingang (E1, E2, E3, ...) und mit jeweils mindestens einem Stromausgang (AI1, AI2, ...) vorgesehen sind, daß die Injektoreingänge aller dieser besagten I²L-Gatter (G1, G2, ...) zu einem mit einem Injektorgesamtstrom ($I_E$) beaufschlagten ersten Schaltungsknoten (K1) zusammengeschaltet sind, daß der Stromausgang (AI1) eines der besagten I²L-Gatter (G1), das als Referenzgatter vorgesehen ist, mit einem Eingang einer Vergleichereinrichtung (VE) verbunden ist, daß der andere Eingang dieser Vergleichereinrichtung (VE) mit der besagten vorgebbaren elektrischen Größe beaufschlagt ist, daß die Ausgangsgröße der Vergleichereinrichtung (VE) zur Ansteuerung eines Regelverstärkers (RV) zur Bereitstellung des Injektorgesamtstromes ($I_E$) vorgesehen ist, daß als Stromausgänge der schaltbaren Konstantstromquelle die Stromausgänge (AI2, AI3, ...) der nicht als Referenzgatter vorgesehenen I²L-Gatter (G2, G3, ...) vorgesehen sind und daß die Ausgangsströme dieser Konstantstromquelle über die entsprechenden Steuereingänge (E2, E3, ...) dieser I²L-Gatter schaltbar sind.

2. Schaltbare Konstantstromquelle nach Anspruch 1, **dadurch gekennzeichnet,** daß der Steuereingang (E1) des als Referenzgatter vorgesehenen I²L-Gatters (G1) unbeschaltet ist.

3. Schaltbare Konstantstromquelle nach Anspruch 1 oder 2, **dadurch gekennzeichnet,** daß die Vergleichereinrichtung aus einem zweiten Schaltungsknoten (K2) besteht.

4. Schaltbare Konstantstromquelle nach Anspruch 1 oder 2, **dadurch gekennzeichnet,** daß die Vergleichereinrichtung (VE) aus einem Differenzverstärker besteht.

5. Schaltbare Konstantstromquelle nach Anspruch 1, 2, 3 oder 4, **dadurch gekennzeichnet,** daß der Regelverstärker (RE) aus einem Transistor besteht.

6. Schaltbare Konstantstromquelle nach Anspruch 1, 2, 3 oder 4, **dadurch gekennzeichnet,** daß der Regelverstärker aus einer Darlington-Transistorschaltung besteht.

7. Schaltbare Konstantstromquelle nach Anspruch 1, 2, 3 oder 4,
**dadurch gekennzeichnet,**
daß als Vergleichereinrichtung (VE) und als Regelverstärker (RV) ein Operationsverstärker (OP) mit Differenz-Eingangsstufe vorgesehen ist.

8. Schaltbare Konstantstromquelle nach einem der vorhergehenden Ansprüche,
**dadurch gekennzeichnet,**
daß der Ausgang des Regelverstärkers über einen Widerstand an den ersten Schaltungsknoten (K1) geschaltet ist.

9. Schaltbare Konstantstromquelle nach einem der Ansprüche 2, 3, 4, 5, 6, 7 oder 8,
**dadurch gekennzeichnet,**
daß zur Verhinderung der Sättigung des als Referenzgatter vorgesehenen I²L-Gatters (G1) der Stromausgang (AI1a) dieses I²L-Gatters (G1), der mit dem Eingang der Vergleichereinrichtung (VE) verbunden ist, nicht unmittelbar an den Eingang dieser Vergleichereinrichtung (VE) geschaltet ist, sondern mit dem Emitteranschluß eines als Kaskodeschaltung eingesetzten Transistors (Tk) verbunden ist, daß der Kollektoranschluß dieses Transistors (Tk) an den Eingang der Vergleichereinrichtung (VE) geschaltet ist und daß der Basisanschluß dieses Transistors (Tk) mit einem geeigneten Potential beaufschlagt ist.

10. Schaltbare Konstantstromquelle nach Anspruch 9,
**dadurch gekennzeichnet,**
daß das Potential am Basisanschluß des als Kaskodeschaltung geschalteten Transistors (Tk) etwa so groß ist, wie zwei PN-Übergangsspannungen.

# FIG 1a

Inj.

$I_{Inj.}$

A1

E

$I_{Aus}$

A2

# FIG 1b

Inj.

$I_{Inj.}$

IB

Ti

E

A2

Ta

# FIG 2

$U_B$

ID

$I_{Inj.}$

E

A1'

$I_{Aus}$

Tb

Tc

A3

IC

# FIG 3

K1

$I_E$

RV

Inj.1

Inj.2

E2

E1

$I_{Ref.}$

G2

G1

AI1

VE

AI2

# FIG 4

$U_B$

Inj.1

AI1b.

Inj.2

AI2b

Inj.3

AI3b

E1

E2

E3

Ri

Rg

G1

AI1a

G2

AI2a

G3

AI3a

$I_E$

K1

$I_{Ref.}$

OP

Inj.4

AI4b

Inj.5

AI5b

IR

E4

E5

G4

AI4a

G5

AI5a

88 P 1 5 5 9 E

## FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | IBM TECHNICAL DISCLOSURE BULLETIN, Band 18, Nr. 4, September 1975, Seiten 1220-1222, New York, US; R.C. JAEGER: "Regulated power supply for MTL integrated circuits" * Der ganze Artikel * --- | 1-4,7 | G 05 F 1/46 H 03 K 19/091 |
| X | GB-A-2 030 810 (PHILIPS) * Das ganze Dokument * ----- | 1-7 | |

**RECHERCHIERTE SACHGEBIETE (Int. Cl.4)**

G 05 F
H 03 K

Der vorliegende Recherchenbericht wurde für alle Patentansprüche erstellt

| Recherchenort | Abschlußdatum der Recherche | Prüfer |
|---|---|---|
| DEN HAAG | 26-04-1989 | ZAEGEL B.C. |

EPO FORM 1503 03.82 (P0403)